Europäisches Patentamt

European Patent Office

Office européen des brevets

(11) Veröffentlichungsnummer : **0 302 552 B1**

(12) **EUROPÄISCHE PATENTSCHRIFT**

(45) Veröffentlichungstag der Patentschrift :
25.09.91 Patentblatt 91/39

(21) Anmeldenummer : 88201584.5

(22) Anmeldetag : 21.07.88

(51) Int. Cl.⁵ : **H01J 35/10, C23C 16/26**

(54) **Drehanode für Röntgenröhren.**

(30) Priorität : 03.08.87 AT 1959/87

(43) Veröffentlichungstag der Anmeldung :
08.02.89 Patentblatt 89/06

(45) Bekanntmachung des Hinweises auf die
Patenterteilung :
25.09.91 Patentblatt 91/39

(84) Benannte Vertragsstaaten :
**CH DE FR GB IT LI NL**

(56) Entgegenhaltungen :
DE-A- 2 146 918
GB-A- 2 055 245
GB-A- 2 084 124
US-A- 4 060 660

(56) Entgegenhaltungen :
THIN SOLID FILMS, Band 35, Nr. 2, 15. Juni
1976, Seiten 255-261, Lausanne, CH; D.S.
WHITMELL et al.: "The deposition of hard
surface layers by hydrocarbon cracking in a
glow discharge"
PATENT ABSTRACTS OF JAPAN, Band 9, Nr.
69 (E-305)[1792], 29. März 1985; & JP-A-59 207
552 (HITACHI SEISAKUSHO K.K.) 24-11-1984

(73) Patentinhaber : **METALLWERK PLANSEE
GESELLSCHAFT M.B.H.**
A-6600 Reutte, Tirol (AT)

(72) Erfinder : **Rödhammer, Peter, Dr.**
**Kirchweg 20**
**A-6600 Reutte (AT)**
Erfinder : **Kailer, Karlheinz**
**Runzfeld 3**
**A-6600 Breitenwang (AT)**

(74) Vertreter : **Lohnert, Wolfgang, Dr.**
**Metallwerk Plansee GmbH**
**A-6600 Reutte, Tirol (AT)**

## Beschreibung

Die Erfindung betrifft ein Verfahren zur Herstellung einer Drehanode für Röntgenröhren mit einem zumindest teilweise aus Graphit bestehenden Grundkörper, bei welcher der massive Graphit zusätzlich mit einem Überzug aus Kohlenstoff versehen ist, sowie die nach diesem Verfahren hergestellte Drehanode.

Moderne Röntgen-Diagnostik-Verfahren wie die Computer-Tomographie erfordern Drehanoden mit möglichst großer Wärmekapazität, was durch Vergrößerung der Abmessungen der Drehanoden erreicht werden kann.

Neben dieser großen Wärmekapazität wird gleichzeitig eine hohe Beschleunigung und Abbremsung der Drehanoden innerhalb kürzester Zeiträume auf bzw. von Drehgeschwindigkeiten bis zu 10.000 U/Min. gefordert.

Herkömmliche Drehanoden bestehen in der Regel aus hochschmelzenden Metallen wie Wolfram, Molybdän oder deren Legierungen. Diese Materialien weisen jedoch ein sehr hohes spezifisches Gewicht auf, so daß bei Verwendung dieser Materialien für Drehanoden für die Computer-Tomographie die Forderung nach schneller Beschleunigung und Verzögerung nicht ohne weiteres erfüllt werden kann.

Für die Herstellung derartiger Drehanoden hat sich Graphit wegen seiner geringen Dichte als brauchbares Material erwiesen. Darüberhinaus weist Graphit im Vergleich zu den hochschmelzenden Metallen ein wesentlich höheres Wärmespeichervermögen und eine bessere thermische Emissivität (Wärmeabstrahlung) auf.

Bei den Graphit-Drehanoden haben im wesentlichen zwei unterschiedliche Bauformen praktische Bedeutung erlangt.

Bei der einen Form besteht der Drehanoden-Grundkörper aus Graphit, der im Brennbahnbereich mit einer dünnen Targetschicht aus einem hochschmelzenden Metall, in der Regel aus einer Wolfram-Rhenium-Legierung, versehen ist. Diese Targetschicht wird vorzugsweise durch spezielle Beschichtungsverfahren wie beispielsweise durch CVD-Verfahren aufgebracht.

Bei der zweiten Form von Graphit-Drehanoden ist die Targetschicht auf einem Grundkörper aus einem hochschmelzenden Metall, wie beispielsweise aus Molybdän oder aus einer Molybdän-Legierung aufgebracht, der außerhalb der Targetschicht mit einem oder mehreren Teilen aus Sintergraphit, vorzugsweise durch Löten, verbunden ist.

Nachteilig bei allen Graphit-Drehanoden ist, daß durch die mechanische Bearbeitung des Sintergraphits Abrieb in Form von feinen Graphitteilchen in der porösen Oberfläche eingelagert wird. Diese eingelagerten feinen Graphitteilchen können auch durch spezielle Reinigungsverfahren, wie beispielsweise durch Reinigung im Ultraschallbad, nur unzureichend entfernt werden. Bei Betrieb der Drehanode in der Röntgenröhre kommt es dann zum sogenannten "Stauben", d.h. feine Graphitteilchen lösen sich, z.B. unter Einwirkung elektrostatischer Kräfte oder durch Zentrifugalkräfte von der Graphitoberfläche und lagern sich innerhalb der Röntgenröhre ab. Dadurch kann es zu Überschlägen in der Röntgenröhre, insbesondere bei Spannungen über 100 kV kommen. Darüberhinaus können im Vakuum der Röntgenröhre Gase, die der Graphit aufgrund seiner großen Porigkeit (üblicherweise etwa 20% des Volumens) absorbiert hat, freigesetzt werden, was zu einer Verschlechterung des Vakuums und damit wiederum zu Betriebsstörungen in Form von Überschlägen führt.

Um dieses "Stauben" und Entgasen von Graphit-Drehanoden möglichst zu vermeiden, ist man dazu übergegangen, die Graphit-Oberfläche mit verschiedenen Überzugsmaterialien zu beschichten und damit gewissermaßen zu versiegeln.

In der DE-A-3134196 = GB-A-2.084.124 wird beispielsweise die Beschichtung einer Drehanode aus Graphit mit einem Überzug aus pyrolytischem Kohlenstoff beschrieben, der durch Zersetzung einer gasförmigen Kohlenwasserstoff-Verbindung bei Temperaturen von 1000°C bis 1100°C gebildet wird. Die Hochspannungsstabilität derartig beschichteter Drehanoden wird zwar bedeutend erhöht, die thermische Emissivität wird jedoch gegenüber Drehanoden mit unbeschichteter Graphit-Oberfläche signifikant verschlechtert, was wiederum eine Einschränkung der Belastbarkeit solcher Drehanoden zur Folge hat.

Ein weiterer Nachteil einer pyrolytisch aufgebrachten Kohlenstoffschicht liegt darin, daß hohe Beschichtungstemperaturen um 1000°C und höher bei einem Druck von $10^3$-$10^5$ Pa (10-1000 mbar) notwendig sind.

Dies hat zur Folge, daß bei Graphit-Drehanoden, bei denen ein oder mehrere Graphitteile mit einem Grundkörper aus hochschmelzendem Metall verlötet sind, die Beschichtung des Graphits vor der Verlötung mit dem Grundkörper erfolgen muß, da der im Zuge der Beschichtung freigesetzte Wasserstoff bei den hohen Beschichtungstemperaturen zu einer Versprödung der in Frage kommenden Lotmaterialien und damit zu einer Schädigung des Werkstoff-Verbundes führen würde.

Ein schwerwiegender Nachteil von pyrolytisch abgeschiedenen Kohlenstoffschichten auf Sintergraphit liegt auch darin, daß es aufgrund der unterschiedlichen Ausdehnungskoeffizienten des Sintergraphits und der pyrolytischen Kohlenstoffschicht zu starken Spannungen in der Schicht kommt, die sich vor allem negativ auf die Thermoschockbeständigkeit auswirken. Auch ein adhäsives oder kohäsives Versagen der Schicht aufgrund mechanischer Einwirkungen tritt bei Vorhandensein von Vorspannungen in der Schicht in der Regel bereits beiniedrigeren Belastungen ein als im Falle einer entspannten Schicht.

Die EP-A-0104515 beschreibt eine Drehanode aus einem metallischen Grundkörper der zumindest teilweise mit einer Schicht aus einem amorphen Kohlenstoff versehen ist. Die Abscheidung der amorphen Kohlenstoffschicht erfolgt mittels einer Gasentladung von Kohlenwasserstoffen. Durch die Schicht aus amorphem Kohlenstoff soll das thermische Emissionsvermögen des metallischen Grundkörpers verbessert werden. Durch die niederen Beschichtungstemperaturen zur Herstellung der amorphen Kohlenstoffschicht werden unerwünschte Reaktionen zwischen Kohlenstoff und metallischem Grundkörper weitgehend vermieden.

Der Vorveröffentlichung ist kein Hinweis dahingehend zu entnehmen, daß eine amorphe Kohlenstoffschicht eine bessere thermische Emissivität oder anderweitige, verbesserte Eigenschaften gegenüber einer pyrolytischen Kohlenstoffschicht aufweist.

Aufgabe der vorliegenden Erfindung ist es, ein Verfahren zur Herstellung einer Drehanode für Röntgenröhren sowie die danach hergestellte Drehanode zu schaffen, die zumindest teilweise aus Graphit besteht und bei welcher der Graphit mit einem Überzug aus Kohlenstoff versehen ist und bei der die thermische Emissivität der beschichteten Graphit-Oberfläche zumindest gleich hoch wie bei unbeschichtetem Graphit ist und die eine verbesserte Thermoschockbeständigkeit gegenüber bekannten mit pyrolytischem Kohlenstoff beschichteten Graphit-Drehanoden aufweist. Darüberhinaus soll die Aufbringung des überzuges auch als letzter Fertigungsschritt, insbesondere nach der Endbearbeitung der Teile und nach der Verlötung eines Metall-Graphitverbundes, möglich sein.

Erfindungsgemäß wird dies dadurch erreicht, daß die Abscheidung der Kohlenstoffschicht durch Zersetzung von Kohlenwasserstoffgasen, vorzugsweise Azetylen oder Propan, in einer aktivierten Gleichspannungsentladung erfolgt.

Bei dieser Art der Abscheidung erfolgt die Zersetzung von Kohlenwasserstoffen unter Einwirkung energetischer Teilchen in einer Gasentladung bei Beschichtungstemperaturen, die deutlich unterhalb der für thermische Dissoziation erforderlichen Temperaturen (mindestens 1000°C), d.h. in einem Temperaturbereich von etwa 200-650°C liegen. Die in dieser Entladung ionisierten Moleküle, Radikale und Atome werden entweder als Ionen auf die als Kathode geschalteten Graphit-Substrate hin beschleunigt oder treffen dort als durch Stöße energetisierte Neutralteilchen auf. In der Folge scheidet sich eine dichte, gut haftende Schicht aus Kohlenstoff an der Oberfläche ab.

Derartig abgeschiedene Kohlenstoffschichten sind gekennzeichnet durch einen extrem feinkristallinen, meist bruchamorphen Aufbau mit Korngrößen unter 0,1 μm, in der Regel auch durch eine Vorzugsorientierung der Mikrokristallite mit der hexagonalen Prismenachse parallel zur Wachstumsrichtung der Schicht. Im Vergleich dazu zeigen pyrolytisch abgeschiedene Kohlenstoffschichten bei den in der Praxis im industriellen Maßstab angewandten Abscheidungsbedingungen in der Regel ein lamellenförmiges Gefüge, das gröber strukturiert ist.

Unter geänderten Abscheidungsbedingungen kann es unter Umständen auch zu einem granularen Gefüge kommen, das jedoch im Vergleich zu einem Gefüge einer erfindungsgemäß abgeschiedenen Kohlenstoffschicht ebenfalls gröber strukturiert ist.

Eine eindeutige Unterscheidungsmöglichkeit zwischen einer pyrolytisch und einer erfindungsgemäß aufgebrachten Kohlenstoffschicht ist durch die unterschiedliche Röntgenbeugung der beiden Schichten gegeben. Erfindungsgemäß abgeschiedene Kohlenstoffschichten weisen einen gegenüber Sintergraphit wesentlich verbreiterten (002)-Röntgenbeugungsreflex auf ($2\Theta > 0,6°$ Halbwertsbreite), während pyrolytisch abgeschiedene Kohlenstoffschichten nahezu keine Verbreiterung zeigen.

Durch die erfindungsgemäß aufgebrachte Beschichtung wird die Loslösung von Graphitpartikeln aus der Oberfläche bei Betrieb der Drehanode stark reduziert und zwar auf ein Maß, wie es auch bei Graphit-Drehanoden, die mit einer pyrolytischen Kohlenstoffschicht überzogen sind, der Fall ist.

Der Mittelwert der Oberflächenrauhigkeit Ra wird durch das erfindungsgemäße Beschichtungsverfahren verringert, jedoch in wesentlich geringerem Ausmaß als bei der pyrolytisch abgeschiedenen Schicht. Der Grad der Verringerung hängt dabei von der vor der Beschichtung vorliegenden Oberflächenrauhigkeit ab. Zur Oberfläche hin offene Poren, deren Durchmesser etwa der doppelten Schichtstärke entspricht, werden beispielsweise noch weitgehend versiegelt.

Aufgrund dieses Versiegelungseffektes und der Verminderung der Oberflächenrauhigkeit war es völlig überraschend, daß es bei der erfindungsgemäß aufgebrachten Beschichtung zu keiner Absenkung, sondern in der Regel sogar zu einer leichten Erhöhung der thermischen Emissivität im Vergleich zu unbeschichtetem Graphit kommt, während es bei einer pyrolytischen überzugsschicht entsprechend dem Stand der Technik zu einer deutlichen Absenkung der Emissivität kommt.

Dieser überraschende Effekt ist auf die im Rasterelektronenmikroskop nachgewiesene höhere Mikrorauhigkeit der erfindungsgemäß abgeschiedenen Kohlenstoffschicht gegenüber einer pyrolytisch abgeschiedenen

3

Überzugsschicht zurückzuführen.

Die Schichtstärke des erfindungsgemäß abgeschiedenen Kohlenstoffüberzuges liegt vorteilhafterweise in einem Bereich zwischen 3 µm und 7 µm.

Unterhalb von 3 µm wird in der Regel keine ausreichende Einbindung der aufgrund der Vorbehandlung gelockerten bzw. aufgrund der lokalen Oberflächengeometrie ausbruchgefährdeten Graphitteilchen in die Überzugsschicht erreicht.

Bei Schichtstärken größer als 7 µm machen sich bereits die Eigenspannungen der erfindungsgemäß abgeschiedenen Kohlenstoffschicht bemerkbar, die in Überlagerung mit den im Betrieb der Drehanoden auftretenden Thermospannungen zu einem Abplatzen der Schicht führen können.

Zur Herstellung einer erfindungsgemäß abgeschiedenen Kohlenstoffschicht kann eine standardmäßige, am Markt erhältliche PVD-Beschichtungsanlage eingesetzt werden.

In einer besonders bervorzugten Variante des Abscheidungs-Verfahrens wird die Abscheidungsrate des Kohlenstoffes durch zusätzliches Verdampfen von graphitischem Kohlenstoff mittels Elektronenstrahlkanonen erhöht.

Auf diese Weise erfolgt die erfindungsgemäße Abscheidung der Kohlenstoffschicht wesentlich schneller, ohne daß nachteilige Auswirkungen auf die Schichteigenschaften auftreten.

Im folgenden wird die Erfindung an Hand von Figuren und an Hand eines Herstellungsbeispieles näher erläutert.

Es zeigen :

Figur 1 die Prinzipzeichnung einer erfindungsgemäß hergestellten Graphit-Verbunddrehanode im Schnitt

Figur 2 die Abkühlkurve einer erfindungsgemäß beschichteten Graphit-Verbunddrehanode im Vergleich mit den Abkühlkurven einer pyrolytisch beschichteten und einer unbeschichteten Graphit-Verbunddrehanode

Figur 3 die rasterelektronenmikroskopische Bruchaufnahme in 6000-facher Vergrößerung eines pyrolytisch beschichteten Graphitteiles

Figur 4 die rasterelektronenmikroskopische Bruchaufnahme in 10000-facher Vergrößerung eines erfindungsgemäß beschichteten Graphitteiles

Eine erfindungsgemäße Graphit-Verbunddrehanode besteht aus einem Grundkörper—1— aus der Molybdänlegierung TZM mit einem Brennbahnbelag—2— aus einer Wolfram-Rhenium-Legierung sowie aus einem auf der Unterseite des Grundkörpers—1— aufgelöteten Graphitteil—3—, der an seiner Oberfläche mit einer plasmalytisch abgeschiedenen Kohlenstoffschicht—4— versehen ist. Die als Beispiel diskutierte Drehanode weist einen Durchmesser von 127 mm auf und besitzt ein Wärmespeichervermögen von etwa 700 kJ bezogen auf eine maximale Betriebstemperatur von 1200°C.

Die Beschichtung der Drehanode erfolgte nach dem nachstehend beschriebenen Verfahren auf einer herkömmlichen Ionenplattier-Beschichtungsanlage mit zwei Elektronenkanonen, die jedoch mit einer zusätzlichen Hilfsanode ausgerüstet ist ("Triodenanordnung").

Die Graphitverbundanode wurde im fertigverlöteten Zustand in einem Ultraschallreinigungsbad einer Vorreinigung unterzogen. Anschließend wurde die Verbundanode einer Vakuumglühung bei 1350°C während einer Zeitdauer von 5 Stunden unterzogen, was eine weitgehende Entgasung des Graphitteiles der Drehanode bewirkte. Nach Abdecken der metallischen Oberflächen wurde die Verbundanode unmittelbar anschließend in die Beschichtungskammer eingebaut. Die Beschichtungskammer wurde auf einen Druck von < 10⁻³ Pa abgepumpt und gleichzeitig durch Strahlungsheizung auf ca. 500°C aufgeheizt. Während dieses Vorganges erfolgte wiederum eine Entgasung des Graphitteiles der Drehanode. Im nachfolgenden Schritt, dem Ionenätzen, wurde die Oberfläche des Graphitteiles in einer Argon-Atmosphäre von 1 Pa bei gedrosselter Saugleistung durch Anlegen einer Gleichspannung von 5 kV während einer halben Stunde atomar gereinigt und gleichzeitig eine Erwärmung der Drehanode auf etwa 650°C vorgenommen.

Daran anschließend wurde der Beschichtungsprozeß durch Zuführung von Propan in die laufende Glimmentladung eingeleitet, wobei der Partialdruck des Propans etwa 50% bis 80% des Gesamtdruckes von 0,5-2 Pa ausmachte. Die Glimmentladung während der Beschichtung wurde durch eine Werkstückspannung von −1000 bis −3000 V (Volt) aufrechterhalten. Durch Anlegen einer Spannung von + 30 bis +100 V (Volt) an die Hilfsanode wurde der Ionisationsgrad des Plasmas erhöht, so daß eine Stromdichte von etwa 0,1 mA/cm² an der Graphitoberfläche erreicht wurde. Zusätzlich wurden zwei in der Beschichtungskammer angeordnete Graphitronden durch die zwei Elektronenstrahlkanonen mit einer Leistung von je 2-4 kW verdampft, wodurch eine Kohlenstoffverdampfungsrate von etwa 2-5 g/h erreicht wurde. Nach einer Beschichtungsdauer von 3 Stunden wurde der Beschichtungsvorgang beendet. Abschließend wurde die Drehanode im Vakuum abgekühlt. Die erfindungsgemäß abgeschiedene Kohlenstoffschicht auf der Graphitoberfläche der Drehanode wies eine Schichtstärke von 5 µm auf.

Im folgenden hurde die erfindungsgemäß beschichtete Graphit-Verbunddrehanode in einem Röhrenprüfstand hinsichtlich ihrer thermischen Emissivität und ihrer Hochspannungsfestigkeit mit zwei Graphit-Verbunddrehanoden gleicher Abmessungen und gleichen Materialaufbaues, und zwar einer mit unbeschichtetem Graphitteil und einer mit pyrolytisch beschichtetem Graphitteil, verglichen.

Zur Ermittlung der thermischen Belastbarkeit hurden die Drehanoden Expositionen mit einer Schußdauer von 6,4 s (Sekunden) bei einer Röhrenspannung von 85 kV und einem Röhrenstrom von 250 mA ausgesetzt.

Um die maximale Betriebstemperatur von 1200°C nicht zu überschreiten, wurden bei der erfindungsgemäßen Drehanode und bei der unbeschichteten Drehanode zwischen den einzelnen Expositionen Pausenzeiten von 150 s (Sekunden) eingelegt, während bei der pyrolytisch beschichteten drehanode die Pausenzeit auf 190 s (Sekunden) erhöht werden mußte, um diese Grenztemperatur nicht zu überschreiten.

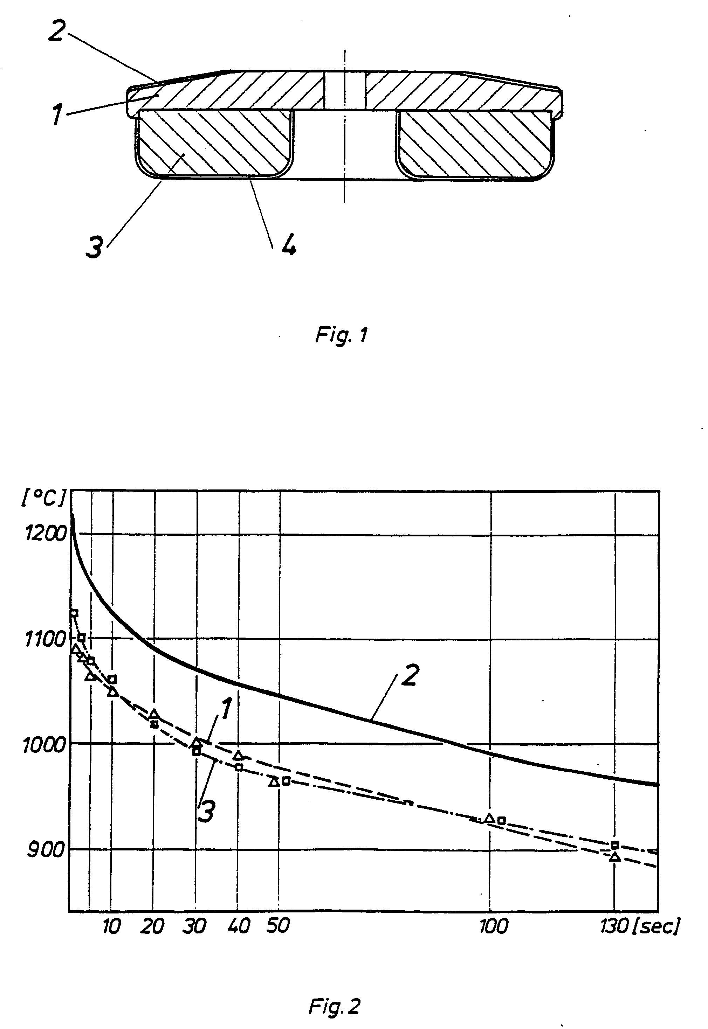

In Figur 2 sind die Temperatur-Zeit-Kurven der drei unterschiedlichen Drehanoden im Röhrenbetrieb wiedergegeben. Die Abkühlkurve der unbeschichteten Drehanode ist mit —1—, die Abkühlkurve der pyrolytisch beschichteten Drehanode mit —2— und die Abkühlkurve der erfindungsgemäß beschichteten Drehanode mit —3— bezeichnet. Die Drehanoden wurden im zyklischen Röhrenbetrieb unter den oben festgelegten Belastungsbedingungen derart aufgeheizt, daß die maximale Betriebstemperatur von 1200°C nicht überschritten wurde (Pausenzeit : 190 s (sec.)), und die Abkühlkurven mit Hilfe eines Spektralpyrometers gemessen. Aufgrund dieser Abkühlkurven folgt für die erfindungsgemäß beschichtete Anode eine im wesentlichen gleiche Strahlungskühlung wie für den unbeschichteten Graphit, während die Anode mit pyrolytisch beschichtetem Graphit deutlich langsamer abkühlt. Dies hat zur Folge, daß die Anode mit pyrolytisch beschichtetem Graphit im Röhrenbetrieb bei deutlich höheren Temperaturen läuft.

Die Messung der thermischen Emissivität erfolgte an einem Strahlungsmeßplatz an erfindungsgemäß und pyrolytisch beschichteten sowie unbeschichteten Probekörpern aus Graphit, wobei die Beschichtung unter den gleichen Bedingungen wie die Beschichtung der Drehanoden erfolgte.

Es ergaben sich folgende Werte (T = 1300 K) :

unbeschichteter Graphit : $\varepsilon$ = 0,78

mit pyrolytischem Kohlenstoff beschichteter Graphit : $\varepsilon$ = 0,63

mit erfindungsgemäßem Kohlenstoff beschichteter Graphit : $\varepsilon$ = 0,80

Im Röntgenröhrenprüfstand wurden die Drehanoden auch auf ihre Hochspannungsfestigkeit überprüft.

Zum Test der Hochspannungsfestigkeit wurde die Röhrenspannung bis auf 180 KV gesteigert. Aus der Häufigkeit der dabei aufgetretenen Überschläge konnte bei der erfindungsgemäßen und der pyrolytisch beschichteten Drehanode eine vergleichbare Hochspannungsfestigkeit festgestellt werden, die gegenüber der unbeschichteten Drehanode wesentlich verbessert war.

Zum Nachweis der verbesserten Thermoschockbeständigkeit einer erfindungsgemäß beschichteten Drehanode wurden Biegestreifen aus Graphit pyrolytisch und erfindungsgemäß mit Kohlenstoff beschichtet. Die pyrolytisch abgeschiedenen Kohlenstoffschichten wiesen im Mittel dreimal so hohe Schichtspannungen wie die erfindungsgemäß abgeschiedenen Kohlenstoffschichten auf, woraus sich eine wesentlich verbesserte Thermoschockbeständigkeit der erfindungsgemäßen Kohlenstoffschicht ableiten läßt.

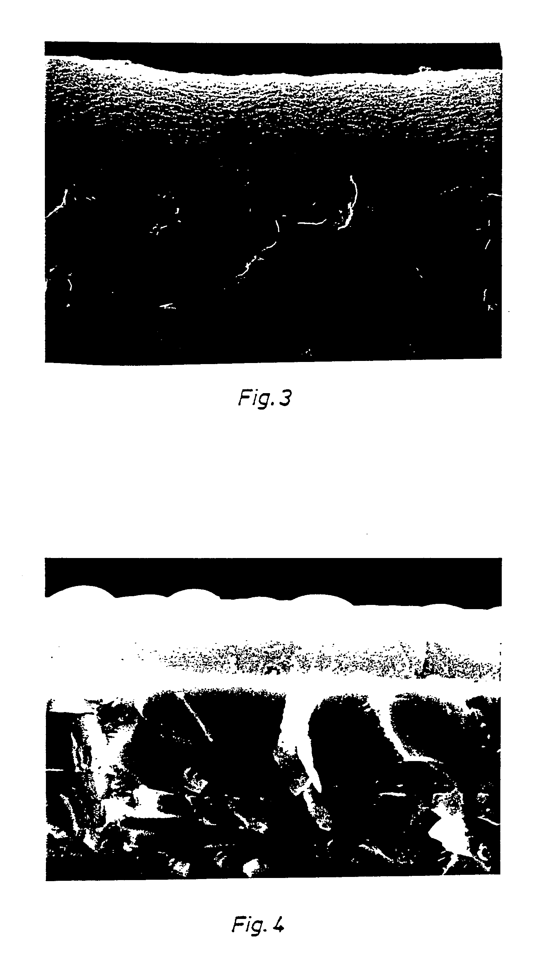

In Figur 3 ist das lamellenförmige Gefüge einer pyrolytisch abgeschiedenen Kohlenstoffschicht zu sehen, das sich deutlich von dem feinkristallinen, bruchamorphen Aufbau einer erfindungsgemäß abgeschiedenen Kohlenstoffschicht entsprechend der Figur 4 unterscheidet.

## Patentansprüche

1. Verfahren zur Herstellung einer Drehanode für Röntgenröhren mit einem zumindest teilweise aus massivem Graphit bestehenden Grundkörper, bei welcher der massive Graphit zusätzlich mit einem Überzug aus Kohlenstoff versehen ist, **dadurch gekennzeichnet,** daß die Abscheidung der Kohlenstoffschicht durch Zersetzung von Kohlenwasserstoffgasen, vorzugsweise Azetylen oder Propan, in einer aktivierten Gleichspannungsglimmentladung erfolgt.

2. Verfahren zur Herstellung einer Drehanode nach Anspruch 1, dadurch gekennzeichnet, daß die Abscheidungsrate des Kohlenstoffs durch gleichzeitige Verdampfung von Graphit mittels Elektronenstrahlkanone erhöht wird.

3. Drehanode für Röntgenröhren, hergestellt nach einem der Ansprüche 1-2, dadurch gekennzeichnet, daß der Kohlenstoffüberzug (4) des Graphits (3) einen feinkristallinen Aufbau mit Korngrößen unter 0,1 µm sowie einen (002)-Röntgenbeugungsreflex mit 2 $\Theta$ > 0,6° Halbwertsbreite aufweist.

4. Drehanode für Röntgenröhren nach Anspruch 3, dadurch gekennzeichnet, daß die Schichtstärke des Kohlenstoffüberzuges (4) 3 µm-7 µm beträgt.

5

5. Drehanode für Röntgenröhren nach einem der Ansprüche 3 bis 4, dadurch gekennzeichnet, daß sie aus einem Graphit-Grundkörper besteht, der zumindest im Brennbahnbereich eine Targetschicht aus Rhenium und/oder einer Wolfram-Rhenium-Legierung aufweist, die auf dem Graphit-Grundkörper aufgebracht ist.

6. Drehanode für Röntgenröhren nach einem der Ansprüche 3 bis 4, dadurch gekennzeichnet, daß sie aus einem Grundkörper aus hochschmelzendem Metall oder einer hochschmelzenden Metall-Legierung besteht, der außerhalb der Targetschicht aus Wolfram oder einer Wolfram-Rhenium-Legierung mit einem oder mehreren Graphitteilen verlötet ist.

## Claims

1. Process for manufacturing a rotating anode for X-ray tubes with a base consisting at least partially of massive graphite, in which the massive graphite is in addition provided with a coating of carbon, characterized in that
the carbon layer is deposited by decomposition of hydrocarbon gases, preferably acetylene or propane, in an activated direct current glow discharge.

2. Process for manufacturing a rotating anode according to Claim 1, characterized in that the deposition rate of the carbon is increased by simultaneous vaporization of graphite by means of an electron beam gun.

3. Rotating anode for X-ray tubes, manufactured according to one of Claims 1-2, characterized in that the carbon coating (4) of the graphite (3) has a fine-crystalline structure with particle sizes below 0.1 $\mu$m and a half-width of the (002) X-ray diffraction line of $2\Theta > 0.6°$.

4. Rotating anode for X-ray tubes according to Claim 3, characterized in that the layer thickness of the carbon coating (4) is 3 $\mu$m-7 $\mu$m.

5. Rotating anode for X-ray tubes according to one of Claims 3 to 4, characterized in that it consists of a graphite base which at least in the focal orbit area has a target layer of rhenium and/or a tungsten-rhenium alloy, which is applied to the graphite base.

6. Rotating anode for X-ray tubes according to one of Claims 3 to 4, characterized in that it consists of a base of high-melting metal or a high-melting metal alloy to which, outside the target layer of tungsten or a tungsten-rhenium alloy, one or several graphite parts are brazed.

## Revendications

1. Procédé de fabrication d'une anode tournante destinée à des tubes à rayons X, comportant un corps de base composé au moins partiellement de graphite massif, dans lequel le graphite massif est en outre pourvu d'un revêtement en carbone,
**caractérisé en ce que**
le dépôt de la couche de carbone est effectué par décomposition de gaz hydrocarboné, de préférence de l'acétylène ou du propane, dans une décharge luminescente activée en tension continue.

2. Procédé de fabrication d'une anode tournante selon la revendication 1, caractérisé en ce que l'allure de dépôt du carbone est accru par une vaporisation simultanée de graphite au moyen d'un canon à faisceau électronique.

3. Anode tournante destinée à des tubes à rayons X fabriquée selon l'une des revendications 1 ou 2, caractérisée en ce que le revêtement de carbone (4) du graphite (3) présente une structure à cristaux fins d'une granulométrie inférieure à 0,1 $\mu$m ainsi qu'un reflet de diffraction X (002) dont la largeur de valeur moyenne est $2\Theta > 0,6°$.

4. Anode tournante destinée à des tubes à rayons X selon la revendication 3, caractérisée en ce que l'épaisseur de couche du revêtement de carbone (4) est de 3 $\mu$m à 7 $\mu$m.

5. Anode tournante destinée à des tubes à rayons X selon l'une des revendications 3 et 4, caractérisée en ce qu'elle se compose d'un corps de base en graphite qui comporte, au moins dans la zone de bande focale, une couche de cible en rhénium et/ou en un alliage tungstène-rhénium qui est déposée sur le corps principal en graphite.

6. Anode tournante destinée à des tubes à rayons X selon l'une des revendications 3 et 4, caractérisée en ce qu'elle se compose d'un corps de base en métal à haut point de fusion ou en un alliage métallique à haut point de fusion, qui est brasée, en dehors de la couche de cible en tungstène ou en un alliage tungstène-rhénium, avec un ou plusieurs éléments en graphite.

Fig. 1

Fig. 2

Fig. 3

Fig. 4